# EUROPÄISCHE PATENTSCHRIFT

(11) **EP 2 652 554 B1**
(45) Veröffentlichungstag und Bekanntmachung des Hinweises auf die Patenterteilung: **05.09.2018**
(21) Anmeldenummer: 11788371.0
(22) Anmeldetag: 17.11.2011
(51) Int. Cl.: G03F 7/20

(54) **VERFAHREN ZUR STRUKTURIERUNG EINER FLEXODRUCKFORM**
METHOD FOR STRUCTURING A FLEXOGRAPHIC PRINTING FORME
PROCÉDÉ PERMETTANT DE STRUCTURER UN CLICHÉ FLEXOGRAPHIQUE

(30) Priorität: 15.12.2010 DE 102010054527
(43) Veröffentlichungstag der Anmeldung: 23.10.2013
(73) Patentinhaber: Merck Patent GmbH, 64293 Darmstadt (DE); Rudolf Reproflex GmbH, 38644 Goslar (DE)
(72) Erfinder: GOETZ, Thomas, 64297 Darmstadt (DE); CLAUTER, Peter, 64319 Pfungstadt (DE); GROPE, Dirk, 37534 Gittelde (DE)
(86) Internationale Anmeldenummer: PCT/EP2011/005802
(87) Internationale Veröffentlichungsnummer: WO 2012/079672

(56) Entgegenhaltungen:
- EP-A1- 2 128 203
- WO-A1-2011/152922
- FR-A1- 2 735 717
- JP-A- 2003 202 676
- US-A- 5 994 026
- US-A1- 2002 197 540

## Beschreibung

Die vorliegende Erfindung betrifft ein Verfahren zur Strukturierung einer Flexodruckform, insbesondere zur Erzeugung einer Struktur in der Reliefschicht einer Flexodruckform, eine nach diesem Verfahren hergestellte strukturierte Flexodruckform sowie deren Verwendung.

Der Flexodruck stellt eine Variante des Hochdrucks (die druckenden Elemente sind erhöht, die nicht druckenden Elemente vertieft) dar, bei der mit elastischen beziehungsweise weichen, flexiblen Druckplatten dünnflüssige Farben mit geringem Anpressdruck zwischen dem die Druckform aufweisenden Formzylinder und dem Bedruckstoff aufgebracht werden können. Bedingt durch die Flexibilität der Druckplatte (in der Regel auf einem Druckzylinder montierte Druckplatte) können verschiedene Bedruckstoffe, unter anderem solche, die anderweitig schwierig zu bedrucken sind, mit einem Flexodruckverfahren in guter Qualität bedruckt werden. Bevorzugte Bedruckstoffe sind unter anderem Papier, Wellpappe verschiedenster Stärken, Tapeten, polymere Folien und auch Textilien. Da der Härtegrad der Druckform an den jeweiligen Bedruckstoff angepasst werden kann und der Anpressdruck gering ist, ist auch das Bedrucken solcher zum Teil unebenen und druckempfindlichen Bedruckstoffe möglich.

Besonders bevorzugt ist der Flexodruck für Verpackungsmaterialien vielfältigster Art, beispielsweise als Wellpappendirektdruck oder zur Herstellung von Folientaschen, Drucketiketten und dergleichen.

Beim Flexodruck wird im allgemeinen zwischen zwei Druckarten unterschieden, dem Flexo-Strichdruck und dem Flexo-Rasterdruck. Einfache Schriftzüge, Logos oder Bildflächen werden im Strichdruck gedruckt, während hochwertige Bildmotive und Halbtöne im Rasterdruckverfahren aufgebracht werden.

In der Regel werden Strich- und Rasterdruck, auch bei gleicher Farbe, mit unterschiedlichen Druckplatten ausgeführt, da die Druckformen für die jeweilige Druckart normalerweise gesondert ausgelegt werden müssen und nur wenige Druckplattenarten verfügbar sind, die universell einsetzbar sind. So ist es für den Rasterdruck beispielsweise unabdingbar, dass die einzelnen Druckelemente (Halbtonpunkte) auf der Oberfläche der Druckform sorgfältig und bei guter Versockelung mit dem Untergrund aus der Druckform herausgearbeitet werden, um saubere detaillierte Drucke zu ermöglichen und Deformationen der Druckelemente während des Druckvorganges und eine damit einhergehende ungenügende Farbübertragung zu vermeiden.

Zur Herstellung von Flexodruckplatten sind verschiedene Verfahren bekannt. Die früher bereits verwendeten Gummiplatten sind mittlerweile wieder stärker in Gebrauch, da sie sich per Laser direkt gravieren lassen.

Gebräuchlich sind auch ein- oder mehrschichtige Flexodruckplatten, deren Reliefschicht aus einem Fotopolymer besteht. Die Bildübertragung des Druckmotivs kann mittels eines fotografischen Negativfilms, der das Druckmotiv trägt und auf der Reliefschicht angeordnet ist, mittels eines auf die Reliefschicht direkt aufgedruckten Bildmotivs oder direkt über eine laserempfindliche und per Laser ablatierte Beschichtung auf der Oberfläche der Reliefschicht (CtP-Verfahren, Computer-to-Plate) erfolgen. In diesen Fällen wird das auf der Oberfläche der Reliefschicht befindliche Bildmotiv, dass sich aus Bildteilen zusammensetzt, die für aktinische Strahlung durchlässig und solchen, die für dieselbe Strahlung gleicher Wellenlänge undurchlässig sind, von der Bildseite her mit aktinischer Strahlung eines bestimmten Wellenlängenbereichs, in der Regel unter Vakuum, belichtet, wodurch das fotopolymere Material in der Reliefschicht an den belichteten Stellen polymerisiert und dadurch vernetzt wird. Danach wird die Motivvorlage entfernt, sofern das möglich ist. Die nicht polymerisierten Anteile in der Reliefschicht werden anschließend ebenfalls entfernt, was mittels eines Waschverfahrens mit organischen Lösemitteln oder auch Wasser, inzwischen aber auch lösemittelfrei mittels eines mechanischthermischen Verfahrens (mit Hilfe saugfähiger Gewebe) erfolgen kann.

Nach dem Trocknen der mit dem Druckmotiv versehenen Druckform erfolgt in der Regel ein vollflächiger Bestrahlungsvorgang der Bildseite abermals mit aktinischer Strahlung, um die vollständige Polymerisation und das Aushärten des Druckmotivs zu bewirken und die Klebrigkeit der Oberfläche der Bildelemente zu verringern. Die so erzeugten bildgemäß entwickelten Druckformen weisen druckende Bildelemente auf, die sich auf der Druckseite in der Regel auf gleicher Höhe befinden und erhaben sind gegenüber den nicht-druckenden Zwischenelementen. Die Reliefhöhe, dass heißt die Höhendifferenz zwischen den druckenden Bildelementen und den nicht-druckenden Elementen, beträgt in der Regel mindestens 100 µm, vorzugsweise 200 bis 700 µm.

Bildmäßig unentwickelte Flexodruckformen, die eine (feste) Fotopolymerschicht als Reliefschicht aufweisen, sind in der Regel aus einer polymeren Trägerschicht, der Reliefschicht aus einem Fotopolymermaterial und einer Schutzschicht zusammengesetzt. Zwischenschichten, die beispielsweise die Haftung der Reliefschicht an der Trägerschicht oder die bessere Ablösung der Schutzschicht von der Reliefschicht ermöglichen sollen, können zusätzlich ebenfalls vorhanden sein.

Damit das über die Belichtung der Reliefschicht von der Seite der Schutzschicht her (nach deren Ablösung) erzeugte Druckbild, welches sich nach seiner Fertigstellung als Druckrelief in der Reliefschicht darstellt, eine gute Verankerung mit dem Untergrund aufweist, wird häufig als erster Schritt zur Entwicklung beziehungsweise Fertigstellung einer druckfähigen Druckplatte eine vollflächige Rückseitenbelichtung mit aktinischer Strahlung durch die polymere Trägerschicht hindurch, die durchlässig für aktinische Strahlung bestimmter Wellenlängenbereiche ist, vorgenommen. Auf diese Weise wird ein relativ geringer Teil der Gesamtschichtdicke der Fotopolymerschicht, von der Trägerseite her betrachtet und an diese anschließend, polymerisiert und/oder vernetzt, so dass es zur Ausbildung eines vollflächigen Sockels aus durch Bestrahlung gehärtetem fotopolymerem Material auf der Druckform kommt. Dieser Sockel dient dazu, das im nächsten Arbeitsschritt wie vorab beschrieben erzeugte Relief in der Reliefschicht, das über die so genannte Hauptbelichtung von der Bildseite aus erzeugt wird, am Sockel zu verankern und damit die Deformierung oder gar das Abreißen von Bildelementen während des Druckvorganges zu verhindern. Durch eine gute und stabile Versockelung der Bildelemente am polymeren Sockel wird auch ein qualitativ hochwertiges Fortdruckverhalten ermöglicht, insbesondere wenn hochauflösende Flexodruckformen für den Rasterdruck eingesetzt werden sollen. Für letztere ist es auch besonders wichtig, dass die Bildflächen der einzelnen Druckelemente (Halbtonpunkte) planar und scharfkantig vorliegen und dass die geraden Flanken der Druckelemente wenn nicht senkrecht, so doch wenigstens in steilem Winkel auf der Grundfläche des Sockels stehen. Diese Eigenschaften sind in der Regel mit der Bildung eines stabilen Sockels und mit einer Hauptbelichtung, die unter Vakuum ausgeführt wird, erreichbar.

US2002/0197540 und FR 2 735 717 offenbaren Verfahren zur Herstellung einer Flexodruckform, wobei eine zweimalige Rückseitenbestrahlung erfolgt.

Es sind jedoch auch Sonderfälle des Einsatzes von Flexodruckformen zum Drucken von Druckbildern mit weniger scharfen Begrenzungen der äußeren Bildkanten bekannt, bei denen großflächige Motive und feine Linien mit unscharfen Außenbegrenzungen gedruckt werden sollen, für die die üblichen Flexodruckformen mit fester Fotopolymerplatte, unabhängig vom jeweiligen Entwicklungs-/Bebilderungsverfahren, nicht optimal geeignet sind, weil damit nur scharf abgegrenzte Bildmotive gedruckt werden können.

Darüber hinaus hat es sich herausgestellt, dass sich bildmäßig entwickelte Flexodruckformen auch artfremd als Prägewerkzeuge zur leichten Nassverprägung von noch unverfestigte Beschichtungen auf Substraten einsetzen lassen und dass die Qualität dieser Prägungen bei bestimmten Beschichtungszusammensetzungen deutlich verbesserungsfähig wäre, wenn die bildmäßig entwickelten Flexodruckformen weniger scharfe Begrenzungslinien der Bildmotive und insgesamt ein deutlich weicheres Relief aufwiesen.

Aufgabe der vorliegenden Erfindung ist es daher, ein Verfahren zur Herstellung einer Struktur in der Reliefschicht einer Flexodruckform zur Verfügung zu stellen, mit Hilfe dessen eine vorzugsweise handelsübliche feste Flexodruckform mit einem Druckrelief versehen werden kann, welches flächige Bildelemente und/oder Strichelemente aufweist, die keine scharfen Begrenzungslinien der Druckoberflächen aufweisen, und welches weiche, abgerundete Strukturformen und ein vorzugsweise flaches Profil besitzt.

Eine weitere Aufgabe der Erfindung besteht darin, eine diese Eigenschaften aufweisende Flexodruckform zur Verfügung zu stellen.

Darüber hinaus besteht eine weitere Aufgabe der Erfindung darin, die Verwendung einer derart hergestellten Flexodruckform aufzuzeigen.

Die Aufgabe der vorliegenden Erfindung wird gelöst durch ein Verfahren gemäß Anspruch 1 zur Herstellung einer Struktur in einer Reliefschicht einer Flexodruckform, wobei die Flexodruckform wenigstens eine polymere Trägerschicht, eine Reliefschicht und eine Schutzschicht, in dieser Reihenfolge, aufweist, und wobei die Reliefschicht eine Fotopolymerschicht ist und die Struktur in der Reliefschicht durch Beaufschlagung der Flexodruckform mit aktinischer Strahlung ausschließlich von der Seite der polymeren Trägerschicht her und durch diese hindurch erzeugt wird.

Zur erfindungsgemäßen Herstellung von Strukturen in der Reliefschicht von Flexodruckformen lassen sich handelsübliche unbelichtete feste Roh-Flexodruckplatten einsetzen, wie sie gewöhnlich auch zur Herstellung gebräuchlicher bildmäßig entwickelter Flexodruckformen verwendet werden. Solche Roh-Flexodruckplatten werden in ein- oder mehrschichtiger Form angeboten.

Flexodruckformen mit einschichtigem Aufbau bestehen zumeist aus einer polymeren Trägerschicht, einer Reliefschicht aus einem Fotopolymer und einer Schutzschicht, wobei optional zwischen der Trägerschicht und der Reliefschicht eine Haftschicht zur Verstärkung der Haftung zwischen beiden Schichten und/oder zwischen der Reliefschicht und der Schutzschicht eine Trennschicht zur Verbesserung der Abtrennung der Schutzschicht, sowie wahlweise noch weitere Hilfsschichten angeordnet sein können. Mehrschichtige Flexodruckformen weisen in der Regel noch zusätzlich mindestens eine weitere Schicht auf, die elastomere Eigenschaften aufweist und durch den Druckvorgang auftretende Druckbelastungen mittels eigener Verformung abfangen kann, ohne dass das Druckrelief beim Drucken in seiner Form verändert wird.

Die polymere Trägerschicht ist vorzugsweise eine polymere Folie und dient der Stabilisierung der Druckform. Als polymere Folie werden beispielsweise eine Polyesterfolie, eine PET-Folie oder auch Fiberglas eingesetzt. Dabei ist wesentlich, dass die polymere Trägerschicht durchlässig ist für die aktinische Strahlung, die zur Strukturbildung in der Fotopolymerschicht eingesetzt wird.

Die Schutzschicht besteht vorzugsweise ebenfalls aus einer dünnen polymeren Folie und kann beispielsweise aus Polystyrol, Polyethylen, Polycarbonat, Fluorpolymeren, Polyamiden oder Polyestern sein. Insbesondere besteht die Schutzschicht aus einem Polyethylenterephthalatfilm. Die Schutzschicht dient dem Schutz der Fotopolymerschicht vor äußeren mechanischen und Strahlungseinflüssen und wird erst dann entfernt, wenn die Beaufschlagung der polymeren Trägerschicht mit aktinischer Strahlung im zweistufigen erfindungsgemäßen Verfahren beendet ist.

Die Fotopolymerschicht besteht aus mindestens einer Schicht, die ein fotopolymerisierbares Material enthält. Als fotopoymerisierbares Material wird ein Material angesehen, das durch Beaufschlagung mit aktinischer Strahlung eine Reaktion oder Reaktionen initiiert, die in der Regel photochemischer Art sind und eine Polymerisation und/oder Vernetzung des Materials durch Bestrahlung hervorrufen. Die Fotopolymerschicht im Sinne der vorliegenden Erfindung ist eine bei Raumtemperatur feste elastomere Schicht, die wenigstens ein Bindemittel, ein Monomer und einen Photoinitiator enthält. Der Photoinitiator reagiert dabei empfindlich auf die Bestrahlung mit aktinischer Strahlung und setzt die oben beschriebenen Reaktionen in Gang. Photoinitiatoren sind Einzelverbindungen oder Gemische von Verbindungen, die sensitiv auf die Einwirkung aktinischer Strahlung unter Bildung von freien Radikalen reagieren, wobei letztere die Polymerisation eines oder mehrerer Monomere ohne frühzeitigen Kettenabbruch einleiten können. Als Photoinitiatoren kommen die allgemein bekannten Klassen von Photoinitiatoren in Betracht, beispielsweise Chinone, Benzopheneone, Arylketone, Peroxide, Diimidazole, Hydroxyalkylphenylacetophenone, Aminoketone oder Sulfonylketone, um nur einige zu nennen.

In der Fotopolymerschicht der Flexodruckformen, die für das erfindungsgemäße Verfahren verwendet werden werden, können auch verschiedene Photoinitiatoren gemeinsam miteinander eingesetzt werden, von denen jeder auf einen anderen Wellenlängenbereich der aktinischen Strahlung sensitiv reagiert. Der oder die Photoinitiatoren sind in der Fotopolymerschicht in der Regel in einem Anteil von 0,001 bis 10,0 %, bezogen auf das Gewicht der Fotopolymerschicht, vorhanden.

Bindemittel für die Fotopolymerschicht können einzelne Polymere oder Polymergemische sein. Die Bindemittel können elastomer sein oder bei Beaufschlagung mit aktinischer Strahlung elastomeres Verhalten entwickeln. Als Bindemittel kommen beispielsweise konjugierte Diolefinkohlenwasserstoffe, wie z. B. Polyisopren, 1,2-Polybutadien, 1,4-Polybutadien, Butadien/Acrylnitril oder thermoplastische Dien/Styrol-Block-Copolymere, aber auch elastomere Block-Copolymere des A-B-A-Typs mit einem nicht-elastomeren A-Block- und einem elastomeren B-Block-Polymer. Dabei kann das A-Blockpolymer beispielsweise ein Vinylpolymer wie Polystyrol und das B-Blockpolymer beispielsweise Polybutadien oder Polyisopren sein. Weitere geeignete Bindemittel finden sich in den Angaben der jeweiligen Hersteller für Roh-Flexodruckplatten. Die Bindemittel können löslich oder quellfähig in Wasser, wässrigen Lösungen oder organischen Waschlösungen sein oder auch thermisch ohne Lösemittelzufuhr herauslösbar, und sind in der Regel beides. Der Anteil des oder der Bindemittel in der Fotopolymerschicht beträgt in der Regel mindestens 50 %, bezogen auf das Gewicht der Fotopolymerschicht.

Die Fotopolymerschicht enthält auch mindestens ein Monomer, welches in der Lage ist, durch Additionspolymerisation zu polymerisieren. Geeignete Monomere sind beispielsweise Acrylatmonoester von Alkoholen und Polyolen, Methacrylatmonoester von Alkoholen und Polyolen, wobei die Alkohole und Polyole Alkanole, Alkylglycole, Trimethylolpropan, ethoxyliertes Trimethylolpropan, Pentaerythritol und Polyacrylol-Oligomere umfassen. Andere geeignete Monomere sind beispielsweise Acrylatderivate und Methacrylatderivate von Isocyanaten. Auch die Monomeren können der Fotopolymerschicht elastomere Eigenschaften verleihen, beispielsweise flüssige Polyisoprene oder flüssige Polybutadiene mit jeweils hohem Anteil an Vinylgruppen.

Neben dem mindestens einen Photoinitiator, Bindemittel und Monomer können in der Fotopolymerschicht noch weitere übliche Hilfs- und Füllstoffe wie Sensibilisatoren, Weichmacher, Mittel zur Einstellung der Rheologie, thermische Polymerisationsinhibitoren, Farbmittel, Antioxidationsmittel, Verlaufshilfsmittel, etc. vorhanden sein.

Wie bereits vorab erwähnt, können zur Durchführung des erfindungsgemäßen Verfahrens allgemein gebräuchliche Roh-Flexodruckplatten verwendet werden, die beispielsweise unter den Handelsnamen Cyrel® der Firma DuPont oder Nyloflex® der Flint Group in verschiedenen Qualitäten und Härtegraden erhältlich sind.

Unter aktinischer Strahlung im Sinne der vorliegenden Erfindung wird ultraviolette und/oder sichtbare Strahlung verstanden. Ultraviolette Strahlung betrifft Spektralstrahlung mit Wellenlängen unter 380 nm. Sichtbare Strahlung umfasst im allgemeinen einen Wellenlängenbereich von ca. 380 bis ca. 780 nm. Für die vorliegende Erfindung sind in der Regel jedoch Wellenlängen von ca. 100 bis ca. 400 nm von Interesse. Je nach Fortschreiten des erfindungsgemäßen Herstellungsverfahrens werden Wellenlängen von 320 bis 400 nm (hier der Einfachheit halber als UV-A-Strahlung bezeichnet, erster und zweiter Bestrahlungsschritt zur Herstellung der Struktur in der Fotopolymerschicht) oder auch Wellenlängen von 100 bis 280 nm (UV-C-Strahlung, Nachhärten und Verfestigen der erhaltenen Struktur, Verminderung der Klebrigkeit der Oberfläche) eingesetzt.

Die Herstellung einer Struktur in der Reliefschicht einer Flexodruckform erfolgt erfindungsgemäß ausschließlich durch Beaufschlagung der Flexodruckform mit aktinischer Strahlung von der Seite der polymeren Trägerschicht her und durch letztere hindurch. Das heißt, dass im Gegensatz zum Stand der Technik erfindungsgemäß zur Herstellung einer Struktur in der Reliefschicht keine Hauptbelichtung von der Bildseite der Reliefschicht her durchgeführt wird.

Das erfindungsgemäße Herstellungsverfahren ähnelt dagegen der im Stand der Technik üblichen Rückseitenbelichtung zur Bildung eines Sockels, weicht jedoch in wesentlichen Teilen von dieser ab.

So erfolgt erfindungsgemäß die Beaufschlagung der Flexodruckform mit aktinischer Strahlung von der Seite des polymeren Trägers aus gesehen in zwei Teilschritten.

In einem ersten Teilschritt erfolgt die Beaufschlagung mit aktinischer Strahlung vollflächig auf die polymere Trägerschicht und durchdringt diese unter Ausbildung eines Sockels. Letzterer weist jedoch, bedingt durch eine vergleichsweise lange Einwirkzeit der aktinischen Strahlung, eine deutlich höhere Dicke auf als der Sockel, der üblicherweise bei den Flexodruckformen des Standes der Technik erzeugt wird.

So wird erfindungsgemäß die Dauer der vollflächigen Einwirkung der aktinischen Strahlung auf die polymere Trägerschicht so ausgewählt, dass sie ausreicht um mindestens 80% der Fotopolymerschicht, bezogen auf die Schichtdicke der Fotopolymerschicht von der Seite der polymeren Trägerschicht aus gesehen und an diese anschließend, polymerisierend zu vernetzen (d.h. zu polymerisieren und/oder zu vernetzen).

Die Einwirkungsdauer der aktinischen Strahlung für den ersten Teilschritt beträgt zwischen 100 und 200 Sekunden und bemisst sich nach der für die jeweilige Flexodruckform vorgegebenen Regelbelichtungszeit für die Hauptbelichtung. Im Allgemeinen werden für den ersten Teilschritt zwischen 20% und 50%, vorzugsweise zwischen 25 und 35%, der Gesamtbelichtungszeit für den ersten und zweiten Teilschritt des erfindungsgemäßen Verfahrens eingesetzt. Im Vergleich zur üblichen Rückseitenbelichtung beträgt erfindungsgemäß die Zeitdauer für die vollflächige Rückseitenbelichtung etwa das 20fache bis 200fache der üblichen Zeitdauer für die Rückseitenbelichtung.

In einem zweiten Teilschritt erfolgt die Beaufschlagung mit aktinischer Strahlung von der Seite des polymeren Trägers aus durch ein bildgebendes Element hindurch.

Als bildgebendes Element können alle für die bildmäßige Belichtung von Flexodruckplatten geeigneten bildgebenden Elemente eingesetzt werden, so lange sie separat oder aber direkt auf der Oberfläche des polymeren Trägers hergestellt werden können. Dabei kann es sich um übliche fotografisch bildmäßig belichtete (Silberhalogenid) Negativ- oder Positivfilme handeln, die statt wie im Stand der Technik üblich auf die Bildseite der Flexodruckform erfindungsgemäß auf die Rückseite der Flexodruckform, nämlich auf die Seite des polymeren Trägers, aufgebracht werden. Es lassen sich aber auch direkt per Inkjet-Verfahren oder mittels anderer Druckverfahren rückseitig auf den polymeren Träger aufgedruckte Bildmotive einsetzen oder aber per Laserdirektgravur hergestellte Bildmotive auf gesonderten, lasersensitiv ausgelegten Polymerfolien oder-platten, die auf der Rückseite des polymeren Trägers aufgebracht werden können. Gemeinsam für alle bildgebenden Elemente ist, dass sie Flächenelemente enthalten, die durchlässig sind für die eingesetzte aktinische Strahlung in diesem Herstellungsschritt (bestimmen die erhabenen Stellen des zu erzeugenden Druckreliefs), und solche Flächenelemente, die undurchlässig sind für diese Strahlung (bestimmen die tieferliegenden Zwischenelemente des zu erzeugenden Druckreliefs). In einer besonders bevorzugten Ausführungsform der vorliegenden Erfindung werden die für die aktinische Strahlung durchlässigen Flächenelemente des bildgebenden Elementes an ihren Außenkanten mit einer Rasterung versehen, die einen Gradienten der Lichtdurchlässigkeit an diesen Stellen erzeugt und die Durchlässigkeit für aktinische Strahlung zu den Begrenzungslinien dieser Flächenelemente hin verringert. Besonders bevorzugt erfolgt diese Verringerung der Lichtdurchlässigkeit eher kontinuierlich als stufenweise. Über die Art der Rasterung und die Länge der gerasterten Strecke kann jeweils die Form des Profils der erhabenen, druckenden Bildelemente auf der zu erzeugenden Flexodruckform wesentlich beeinflusst werden. So lässt sich beispielsweise ein Halbkreis- oder Kreissegmentprofil des erhabenen Bildelementes über ein zur Begrenzungslinie des Bildelementes hin abfallendes Raster mit einer Flächendeckung von 100 bis 0 % erzeugen, wobei der Radius des Kreises umso geringer ist, je kürzer die gerasterte Strecke ausfällt. Das Verfahren zur Rasterung dieser lichtdurchlässigen Flächenelemente entspricht den üblicherweise für die Bebilderung von Flexodruckplatten per Fotonegativfilmen, lasergravierten Musterplatten oder aufgedruckten Motiven eingesetzten Rasterungsverfahren und ist dem Fachmann vertraut. Es bedarf hier daher keiner weiteren Erläuterung.

Wie vorab bereits erwähnt können auch im erfindungsgemäßen Verfahren für den Bebilderungsschritt fotografisch belichtete Filme verwendet werden, die, da sie auf die Rückseite der Flexodruckform aufgebracht werden, vorzugsweise das seitenrichtige Negativbild des zu erzeugenden Druckreliefs wiedergeben.

Das bildgebende Element wird so ausgewählt, dass die für aktinische Strahlung durchlässigen Flächenareale überwiegend aus Bild- und/oder Strichelementen bestehen und eine Breite von mindestens 0,5 mm aufweisen.

Das bildgebende Element wird auf die Rückseite der Roh-Flexodruckform, also auf die Rückseite des polymeren Trägers, aufgebracht und liegt in der Regel formschlüssig mit letzterem vor. Die Erzeugung eines Vakuums für die Belichtung mit aktinischer Strahlung ist, im Unterschied zur üblichen Hauptbelichtung im konventionellen Belichtungsverfahren, nicht notwendig.

Allerdings erweist sich die Erzeugung eines Vakuums auch hier als vorteilhaft.

Auf der der Rückseite des bildgebenden Elementes zugewandten Seite wird die Strahlungsquelle für die aktinische Strahlung angeordnet. Das bildgebende Element befindet sich also zwischen dem polymeren Träger und dieser Strahlungsquelle.

Die Dauer der Einwirkung der aktinischen Strahlung auf die polymere Trägerschicht durch das bildgebende Element hindurch für den zweiten Belichtungs-Teilschritt wird so ausgewählt, dass sie ausreicht um die verbleibenden oberen höchstens 20% der Fotopolymerschicht, bezogen auf die Schichtdicke der Fotopolymerschicht von der Seite der polymeren Trägerschicht aus gesehen, die im ersten Teilschritt nicht polymerisiert werden, polymerisierend zu vernetzen (d.h. zu polymerisieren und/oder zu vernetzen).

Die Einwirkungsdauer der aktinischen Strahlung für den zweiten Teilschritt liegt im Bereich zwischen 120 und 300 Sekunden, ist aber jeweils länger als die Zeitdauer für den ersten Teilschritt. Im Allgemeinen werden für den zweiten Teilschritt zwischen 50 und 80%, vorzugsweise zwischen 65 und 75%, der Gesamtbelichtungszeit für den ersten und zweiten Teilschritt des erfindungsgemäßen Verfahrens eingesetzt.

Die Gesamtbelichtungsdauer mit aktinischer Strahlung im erfindungsgemäßen Verfahren für den ersten und zweiten Teilschritt (Strukturbildung) beträgt maximal 70% der Gesamtbelichtungsdauer (Rückseitenbelichtung und Hauptbelichtung) für ein konventionelles Verfahren zur Herstellung einer Struktur in der Reliefschicht einer (Fotopolymer)-Flexodruckform.

Die Beaufschlagung mit aktinischer Strahlung im ersten und zweiten Teilschritt des erfindungsgemäßen Verfahrens erfolgt mit gleichbleibender Lichtstärke im Bereich von 16 bis 19 mW/cm², vorzugsweise von 15 bis 18 mW/cm². Es werden die üblicherweise für die Belichtung von Roh-Flexodruckformen eingesetzten Belichtungsgeräte verwendet, nämlich beispielsweise ein Belichtungsgerät der Fa.lnterflex Jet Europe vom Typ IF 12/20 Expo.

Die aktinische Strahlung für den ersten und zweiten Teilschritt des erfindungsgemäßen Verfahrens ist überwiegend UV-Strahlung, und zwar UV-A-Strahlung (gegebenenfalls in Kombination mit sichtbarer Strahlung) im Wellenlängenbereich von 320 bis 400 nm.

Durch die Beaufschlagung mit aktinischer Strahlung gemäß der vorliegenden Erfindung wird in der Fotopolymerschicht der Roh-Flexodruckform ein Relief erzeugt, welches aus einem vergleichsweise dicken Sockel und aus Bild- und/oder Strichelementen mit einer Breite von mindestens 0,5 mm besteht, die durch die Einwirkung der aktinischen Strahlung polymerisiert und/oder vernetzt in der Fotopolymerschicht vorliegen, wobei die Bild- und/oder Strichelemente eine vergleichsweise geringe Profiltiefe aufweisen. Da die so erzeugten Bild- und/oder Strichelemente in der Fotopolymerschicht jedoch noch von nicht polymerisiertem/vernetztem fotopolymerem Material umgeben sind, muss in den folgenden Arbeitsschritten das erfindungsgemäß erzeugte Relief freigelegt werden.

Das Freilegen und Nachbehandeln des Reliefs in der Fotopolymerschicht geschieht in Anlehnung an das übliche Verfahren zur Erzeugung von bildmäßig belichteten Flexodruckformen.

Nach Beendigung des zweiten Teilschritts für die Beaufschlagung mit aktinischer Strahlung wird daher zunächst die Schutzschicht sowie gegebenenfalls die Trennschicht und optional auch weitere sich auf der Bildoberfläche der Fotopolymerschicht befindlichen Hilfsschichten abgetrennt. Anschließend erfolgt die Entfernung der nicht polymerisierten bzw. vernetzten Anteile des Fotopolymers aus der Fotopolymerschicht. Dieses Entfernen kann mit üblichen Methoden erfolgen, und zwar über einen allgemein gebräuchlichen Auswaschschritt, der mit Wasser, wässrigen Lösemittelgemischen, aber auch mit organischem Lösemittel oder Lösemittelgemisch erfolgen kann, aber auch mit Hilfe eines mechanischthermischen Verfahrens, bei dem die nicht polymerisierten Anteile in der Fotopolymerschicht mittels erhöhter Temperatur erweicht und über saugfähige Gewebe aus der Fotopolymerschicht herausgelöst werden.

Diese Verfahren sind dem Fachmann allgemein bekannt. Da für das erfindungsgemäße Verfahren übliche Flexodruckform-Rohlinge eingesetzt werden können, sind für diesen Schritt die Angaben des jeweiligen Herstellers heranzuziehen, denn die üblichen Belichtungsverfahren enthalten diesen Arbeitsschritt ebenfalls. Nach dem Entfernen der nicht polymerisierten Anteile aus der Fotopolymerschicht bleibt eine sichtbare Struktur und damit ein sichtbares (Druck)relief in der Fotopolymerschicht zurück.

An den Auswaschschritt bzw. das thermische Entfernen für den nicht polymerisierten Anteil der Fotopolymerschicht schließt sich im Allgemeinen ein Trocknungsschritt an, bei dem die gegebenenfalls noch enthaltenen Lösemittelanteile entfernt werden. Je nach Art der verwendeten Roh-Flexodruckform kann ein solcher Trocknungsschritt auch im erfindungsgemäßen Herstellungsverfahren erforderlich sein.

Zur Vervollkommnung der Polymerisation der verbliebenen Anteile in der Reliefschicht und/oder zur Verminderung der Klebrigkeit der erhaltenen Struktur in der Reliefschicht schließt sich vorzugsweise ein ein- oder mehrmaliges Nachbelichten der Reliefschicht von deren Oberseite (Bildseite) aus an. Gleichzeitig wird dadurch die im erfindungsgemäßen Verfahren erhaltene Struktur in der Reliefschicht verfestigt.

Für den Nachbelichtungsschritt mit aktinischer Strahlung wird in der Regel UV-A-Strahlung (Wellenlängen von 320 bis 400 nm) sowie zusätzlich UV-C-Strahlung mit Wellenlängen von 100 bis 280 nm verwendet.

Der Nachbelichtungsschritt erfolgt erfindungsgemäß über eine Zeitdauer von 15 bis 25 min, vorzugsweise mit etwa gleichen Anteilen von UV-A und UV-C-Strahlung, und mit einer Lichtstärke von etwa 10 bis etwa 15 mW/cm², abhängig von der jeweiligen Strahlung. Es können die üblichen Geräte für die Nachbelichtung eingesetzt werden, nämlich beispielsweise ein Finisher der Fa. Flint Group vom Typ Flint Finisher FV oder ein Finisher der Fa. Jet Europe vom Typ IF 12/20 Finish.

Die mittels des erfindungsgemäßen Verfahrens in der Fotopolymer-Reliefschicht einer Flexodruckform erzeugte Struktur weist erhabene ununterbrochene Bildelemente und/oder Strichelemente mit einer Breite von mindestens 0,5 mm, und unterhalb der Höhe der Bild- und Strichelemente liegende Zwischenelemente auf, wobei die Tiefe der Zwischenelemente (Zwischentiefe) höchstens 50 µm in Relation zur Oberfläche der Bild- und Flächenelemente beträgt. Das heißt, dass die Relieftiefe der erhaltenen Struktur höchstens 50 µm beträgt. Dabei bemisst sich die Relieftiefe nach der Höhendifferenz zwischen der äußeren (Druck)Oberfläche der bildmäßig entwickelten Flexodruckform und der Oberfläche, die durch die äußere Oberfläche des Sockels gebildet wird. Mit dem erfindungsgemäßen Verfahren werden Reliefs erhalten, bei denen mehr als 50%, vorzugsweise mehr als 75%, der Bild- und/oder Strichelemente ein- und dieselbe Zwischentiefe (Relieftiefe) aufweisen, die erfindungsgemäß kleiner oder gleich 50 µm ist. Darüber hinaus können auch bis 50%, vorzugsweise bis zu 25%, an Bild- und Strichelementen vorliegen, bei denen die Zwischentiefen zwischen den einzelnen Bild- und Strichelementen geringer sind als 50 µm, nämlich deutlich geringer als der überwiegende Teil der Zwischentiefen. Welche Zwischentiefen in welcher Verteilung vorliegen, ist von der aktuellen Musterung der gewünschten Struktur abhängig und wird nach den Anforderungen des jeweiligen Nutzers und den Nutzungsbedingungen der fertigen Flexodruckform festgelegt.

Im Vergleich zu konventionell belichteten Flexodruckformen weisen die erfindungsgemäß belichteten (bildmäßig entwickelten) Flexodruckformen eine flache Struktur und Bild- und/oder Strichelemente auf, die sehr weiche Konturen besitzen.

Diese weichen Konturen können näherungsweise so beschrieben werden, dass der Querschnitt der Bild- und/oder Strichelemente eine planare äußere (Druck)Oberfläche und seitliche Flanken aufweist, wobei der Übergang von der planaren Oberfläche zur seitlichen Flanke (wird bei Halbton-Rasterpunkten als Schulter bezeichnet) die Form eines Kreisbogens aufweist und wobei die Länge dieses Kreisbogens aus einem Bereich ausgewählt ist, den die Länge eines Kreisbogens aufweisen kann, der über einem Mittelpunktswinkel im Bereich von 10° bis 90° in einem Kreis gebildet wird. Dabei entspricht der Kreisradius einem Wert zwischen 0,1 und 50 µm. Gleichzeitig nähern sich die seitlichen Flanken der durch den Sockel gebildeten inneren Oberfläche der Struktur nahezu asymptotisch, schmiegen sich also an diese innere Oberfläche an. Es versteht sich von selbst, dass die seitlichen Flanken der Bild- und/oder Strichelemente unter diesen Bedingungen keine Geraden darstellen, sondern eher eine einem S-Haken mit geradem Zwischenstück ähnelnde Form annehmen.

In einer weiteren Ausführungsform weisen die Bild- und/oder Strichelemente einen Querschnitt auf, der die Form eines Kreissegmentes aufweist, wobei die Segmenthöhe maximal 50 µm entspricht und wobei der Radius des entsprechenden Kreises im Bereich von 100 bis 2000 µm, vorzugsweise von 100 bis 1000 mm, liegt. Der Radius bemisst sich dabei nach dem Abstand der Oberfläche des bildgebenden Elementes (die Oberfläche, die der Lichtquelle für aktinische Strahlung für die Rückseitenbelichtung zugewandt ist) von der äußeren Oberfläche des erhabenen Bildelementes und wird daher von der Dicke des bildgebenden Elementes, der Dicke des Kunststoffträgers der Druckform, der Dicke der Fotopolymerschicht und ggf. zusätzlich vorhandener Zwischenschichten bestimmt.

Die Aufgabe der Erfindung wird auch durch eine Flexodruckform mit einer Reliefschicht gelöst, die an ihrer Oberfläche eine Struktur aus erhabenen ununterbrochenen Bildelementen und/oder Strichelementen mit einer Breite von mindestens 0,5 mm, und aus unterhalb der Höhe der Bild- und Strichelemente liegenden Zwischenelementen aufweist, wobei die Tiefe der Zwischenelemente höchstens 50 µm in Relation zur Oberfläche der Bild- und Flächenelemente beträgt.

Der Querschnitt der Bild- und/oder Strichelemente, die Form der seitlichen Flanken und der Übergänge zu den jeweiligen inneren und äußeren Oberflächen der Struktur gestaltet sich dabei wie oben bereits beschrieben.

Flexodruckformen dieser Art sind bisher nicht in Gebrauch, weil sie sich für das Drucken von feinen, scharf begrenzten Linien und Bildelementen und damit für den üblichen Gebrauch von Flexodruckformen nicht eignen. Im Gegenteil scheinen die weiche Struktur in der Reliefschicht und das flache Profil gegen den bestimmungsgemäßen Gebrauch von Flexodruckformen zu sprechen.

Überraschend hat sich daher herausgestellt, dass die erfindungsgemäß hergestellten Flexodruckformen sowohl im Flexodruck als auch anderweitig in vorteilhafter Weise eingesetzt werden können.

Die Aufgabe der Erfindung wird demzufolge auch durch die Verwendung einer nach dem erfindungsgemäßen Verfahren hergestellten Flexodruckform als Prägewerkzeug für eine unverfestigte bindemittelhaltige Beschichtung auf einem Substrat oder zur Übertragung von Druckfarbe in einem Flexodruckverfahren gelöst.

Es hat sich herausgestellt, dass die mittels des erfindungsgemäßen Verfahrens hergestellten Flexodruckformen in besonders vorteilhafter Weise zum nassen Verprägen von noch unverfestigten bindemittelhaltigen und optional auch farbmittelhaltigen Beschichtungen eingesetzt werden können, wenn diese Beschichtungen sich auf einem Substrat befinden und beim Prägevorgang lediglich die Beschichtung, nicht jedoch das Substrat verprägt werden soll. Die Verprägung der noch unverfestigten bindemittelhaltigen Beschichtung kann mit sehr geringem Anpressdruck durchgeführt und in eine übliche Flexodruckstrecke integriert werden, wenn nach dem Verfestigen der Schicht noch farbgebende Druckvorgänge ausgeführt werden sollen. Der Grad der erzielbaren Verprägung ist dabei minimal, so dass sichtbare, aber nicht fühlbare Verprägungen entstehen.

Als besonders vorteilhaft hat es sich herausgestellt, wenn die bindemittelhaltigen Beschichtungen als Farbmittel plättchenförmige Effektpigmente enthalten. Bedingt durch die weichen Strukturen an der (Druck)Oberfläche der erfindungsgemäßen Flexodruckformen weisen auch die in der bindemittelhaltigen Schicht erzielten geprägten Strukturen sehr weiche Konturen auf, an die sich die in der noch unverfestigten Schicht befindlichen plättchenförmigen Effektpigmente anschmiegen. Die plättchenförmigen Effektpigmente werden also in der sie enthaltenden Schicht desorientiert und bilden, da sie sichtbare Effekte in dieser Schicht erzeugen, durch ihre Desorientierung nach dem Verfestigen der sie enthaltenden Schicht dreidimensionale sichtbare Strukturen mit interessanten optischen Effekten aus. Diese Strukturen weisen ebenfalls ein sehr weiches und optisch gefälliges äußeres Erscheinungsbild auf, was für viele dekorative Anwendungen sehr erwünscht ist. Auch die durch magnetische Orientierung magnetisierbarer Pigmente im magnetischen Feld erzielbaren optischen Effekte können auf diese Weise nachempfunden werden, ohne dass dafür der Einsatz magnetisierbarer Pigmente und der entsprechenden Apparaturen erforderlich ist. Ein entsprechendes Verfahren ist in der gleichzeitig anhängigen Patentanmeldung DE.......... beschrieben.

Wenn Flexodruckformen mit den erfindungsgemäß hergestellten Strukturen in der Reliefschicht zur Übertragung von Farbe auf Bedruckstoffe in einem üblichen Flexodruckverfahren eingesetzt werden, entstehen Druckbilder aus Bild- und/oder Linienelementen mit fließenden, verwaschen wirkenden Außenstrukturen. Auch die so erzeugten bedruckten Gegenstände lassen sich insbesondere für interessante dekorative Anwendungen einsetzen.

Die vorliegende Erfindung stellt daher ein Verfahren zur Herstellung von Strukturen in der Reliefschicht von Flexodruckformen zur Verfügung, mit Hilfe dessen besonders geformte Strukturen erhalten werden können, die zur Ausbildung von dreidimensionalen Strukturen in Beschichtungen ebenso eingesetzt werden können wie zur speziellen Übertragung regulärer Flexodruckfarben im gewöhnlichen Flexodruckverfahren. In beiden Fällen können optisch interessante, insbesondere dekorative Effekte auf und mit den so erhaltenen Endprodukten erhalten werden.

Die vorliegende Erfindung soll nachfolgend anhand von Abbildungen und eines Beispiels näher erläutert, aber nicht auf diese beschränkt werden.
- Abbildung 1: zeigt die vergrößerte Aufnahme eines Bildmotivs auf einer herkömmlich hergestellten Flexodruckform
- Abbildung 2: zeigt die vergrößerte Aufnahme eines Bildmotivs auf einer nach dem erfindungsgemäßen Verfahren hergestellten Flexodruckform

### Erfindungsbeispiel:

Eine handelsübliche Lackplatte für den Flexodruck mit transparentem Kunststoffträger (Typ CL4 der Fa. DuPont, Plattenstärke 1,14 mm) wird von der Rückseite her durch den Kunststoffträger hindurch vollflächig in einem Flachbelichter (Fa. Interflex Jet Europa, Typ IF 12/20 3000, Röhren: Phillips R-UVA TL 80W/10R) 100 Sekunden lang belichtet. Anschließend wird ein üblicher Fotonegativfilm auf die Rückseite (Kunststoffträger) der Lackplatte aufgebracht. Als Fotonegativfilm wird ein Mattfilm mit Schwärzung eingesetzt, der das aufzubringende Muster trägt und bei dem die Bildstellen durchsichtig und für UV-A-Strahlung durchlässig, die Nichtbildstellen jedoch geschwärzt sind. Durch diesen Fotonegativfilm hindurch wird die Rückseite der Lackplatte mit denselben Röhren wie im ersten Belichtungsschritt erneut, diesmal für 250 Sekunden, belichtet.

Anschließend wird die belichtete Lackplatte in einem gebräuchlichen Flexoplattenwascher mit Lösemittel ausgewaschen (Auswaschgerät Smart XXL der Fa. DuPont, Geschwindigkeit 11 cm/min). Als Lösemittel wird Nylosolv A der Fa. Flint Group eingesetzt.

Wenn der Auswaschprozess beendet ist, wird die nunmehr das Druckrelief aufweisende Lackplatte in einem üblichen Trockner 60 Minuten bei 60°C getrocknet (Flint Dryer FV, Fa. Flint Group).

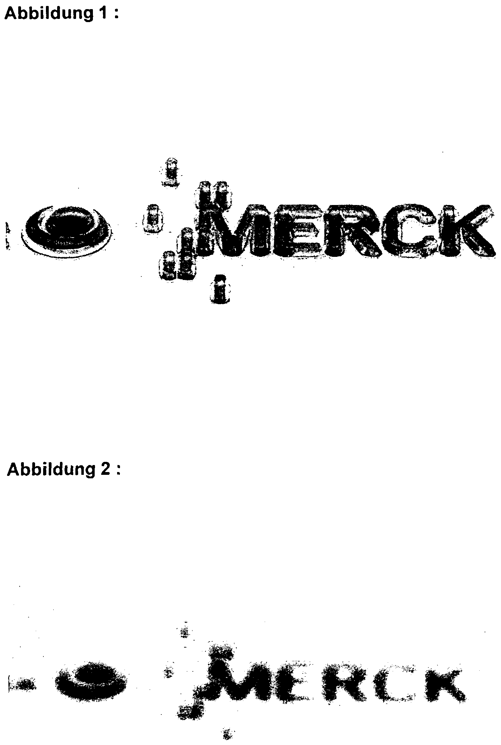

Zur Festigung der Oberfläche des Druckreliefs wird eine Oberflächenabschlussbehandlung, das so genannte Finishing, durchgeführt. Das Finishing verhindert auch ein Quellen der Platte beim bestimmungsgemäßen Einsatz. Es wird ein Finisher der Fa. Flint Group vom Typ Flint Finisher FV eingesetzt. Das Druckrelief wird von der Reliefseite her 10 Minuten bei einer Wellenlänge von 320 bis 400 nm (UV-A) mit einer Lichtintensität von 11 mW/cm² und weitere 10 Minuten mit einer Wellenlänge von 100 bis 280 nm (UV-C) mit einer Lichtintensität von 13 mW/cm² bestrahlt. Die das verfestigte Druckrelief aufweisende Flexodruckplatte ist in Figur 2 dargestellt.

Die angegebenen Roh-Flexodruckplatten und Geräte sind nur beispielhaft genannt und können durch kommerziell verfügbare Fotodruckplatten und entsprechende Geräte anderer Hersteller ersetzt werden, ohne das Ergebnis des erfindungsgemäßen Verfahrens zu beeinträchtigen.

## Patentansprüche

1. Verfahren zur Herstellung einer Struktur in einer Reliefschicht einer Flexodruckform, wobei die Flexodruckform wenigstens eine polymere Trägerschicht, eine Reliefschicht und eine Schutzschicht, in dieser Reihenfolge, aufweist und wobei die Reliefschicht eine Fotopolymerschicht ist und die Struktur in der Reliefschicht durch Beaufschlagung der Flexodruckform mit aktinischer Strahlung ausschließlich von der Seite der polymeren Trägerschicht her und durch diese hindurch erzeugt wird, wobei die Beaufschlagung mit aktinischer Strahlung in zwei Teilschritten, nämlich in einem ersten Teilschritt vollflächig auf die polymere Trägerschicht und in einem zweiten Teilschritt durch ein bildgebendes Element hindurch erfolgt, welches Teilflächen aufweist, die durchlässig, und Teilflächen, die undurchlässig für die aktinische Strahlung sind, wobei sich das bildgebende Element zwischen der polymeren Trägerschicht und einer Strahlungsquelle für aktinische Strahlung befindet und wobei die Dauer der Beaufschlagung mit aktinischer Strahlung für den ersten Teilschritt ausreicht um mindestens 80 % der Fotopolymerschicht polymerisierend zu vernetzen, und die Dauer der Beaufschlagung mit aktinischer Strahlung für den zweiten Teilschritt ausreicht, um an den Stellen, an denen das bildgebende Element durchlässig für die aktinische Strahlung ist, die verbleibenden höchstens 20 % der oberen Fotopolymerschicht, jeweils bezogen auf die Schichtdicke der Fotopolymerschicht von der Seite der polymeren Trägerschicht aus gesehen, polymerisierend zu vernetzen.

2. Verfahren gemäß Anspruch 1, **dadurch gekennzeichnet, dass** die Flexodruckform zusätzlich eine haftungsvermittelnde Schicht zwischen der polymeren Trägerschicht und der Reliefschicht und/oder eine Trennschicht zwischen der Reliefschicht und der Schutzschicht aufweist.

3. Verfahren gemäß Anspruch 1 oder 2, **dadurch gekennzeichnet, dass** die für aktinische Strahlung durchlässigen Teilflächen des bildgebenden Elementes an ihren Außenrändern eine Rasterung aufweisen.

4. Verfahren gemäß einem oder mehreren der Ansprüche 1 bis 3, **dadurch gekennzeichnet, dass** die Dauer der Beaufschlagung mit aktinischer Strahlung für den ersten Teilschritt kürzer ist als die Dauer der Beaufschlagung mit aktinischer Strahlung für den zweiten Teilschritt.

5. Verfahren gemäß einem oder mehreren der Ansprüche 1 bis 4, wobei der erste Teilschritt in einem Zeitrahmen von 100 bis 200 Sekunden und der zweite Teilschritt in einem Zeitrahmen von 120 bis 300 Sekunden bei jeweils gleicher Wellenlänge ausgeführt wird.

6. Verfahren gemäß einem oder mehreren der Ansprüche 1 bis 5, **dadurch gekennzeichnet, dass** nach Beendigung des zweiten Teilschrittes für die Beaufschlagung mit aktinischer Strahlung die Schutzschicht sowie optional die Trennschicht von der Reliefschicht entfernt und anschließend die nicht vernetzten Anteile des Fotopolymers aus der Reliefschicht entfernt werden, wobei eine Struktur in der Reliefschicht entsteht.

7. Verfahren gemäß einem oder mehreren der Ansprüche 1 bis 6, **dadurch gekennzeichnet, dass** die Polymerisation des Fotopolymers in der Reliefschicht vervollkommnet und die erhaltene Struktur in der Reliefschicht verfestigt wird, indem mit aktinischer Strahlung von der Seite der Reliefschicht aus vollflächig nachbelichtet wird.

8. Verfahren gemäß einem oder mehreren der Ansprüche 1 bis 7, **dadurch gekennzeichnet, dass** in der Reliefschicht eine Struktur aus erhabenen ununterbrochenen Bildelementen und/oder Strichelementen mit einer Breite von mindestens 0,5 mm und aus unterhalb der Höhe der Bild- und Strichelemente liegenden Zwischenelementen erhalten wird, von denen letztere eine Tiefe von höchstens 50 µm in Relation zur Oberfläche der Bild- und Strichelemente aufweisen.

9. Verfahren gemäß Anspruch 8, **dadurch gekennzeichnet, dass** Bildelemente und/oder Strichelemente erhalten werden, die eine planare Oberfläche und seitliche Flanken aufweisen, wobei der Übergang von der planaren Oberfläche zur seitlichen Flanke die Form eines Kreisbogens aufweist und die Länge des Kreisbogens ausgewählt ist aus dem Bereich der Länge eines Kreisbogens, der über einem Mittelpunktswinkel im Bereich von 10° bis 90° gebildet wird, wobei der Kreisradius zwischen 0,1 und 50 µm beträgt.

10. Verfahren gemäß Anspruch 8, **dadurch gekennzeichnet, dass** Bildelemente und/oder Strichelemente erhalten werden, die einen Querschnitt aufweisen, der der Form eines Kreissegmentes entspricht, wobei die Segmenthöhe maximal 50 µm entspricht und der Radius des jeweiligen Kreises im Bereich von 100 bis 2000 µm liegt.

11. Flexodruckform mit einer Reliefschicht, die an ihrer Oberfläche eine Struktur aus erhabenen ununterbrochenen Bildelementen und/oder Strichelementen mit einer Breite von mindestens 0,5 mm, und aus unterhalb der Höhe der Bild- und Strichelemente liegenden Zwischenelementen aufweist, wobei die Tiefe der Zwischenelemente höchstens 50 µm in Relation zur Oberfläche der Bild- und Flächenelemente beträgt, erhältlich nach einem Verfahren gemäß einem oder mehreren der Ansprüche 1 bis 10.

12. Verwendung einer Flexodruckform gemäß Anspruch 11 als Prägewerkzeug für eine unverfestigte bindemittelhaltige Beschichtung auf einem Substrat oder zur Übertragung von Druckfarbe in einem Flexodruckverfahren.

13. Verwendung gemäß Anspruch 12, **dadurch gekennzeichnet, dass** die bindemittelhaltige Beschichtung zusätzlich plättchenförmige Effektpigmente enthält.

## Claims

1. Process for the production of a structure in a relief layer of a flexographic printing plate, where the flexographic printing plate has at least one polymeric support layer, a relief layer and a protective layer, in this sequence, and where the relief layer is a photopolymer layer and the structure in the relief layer is produced by exposing the flexographic printing plate to actinic radiation exclusively from the side of the polymeric support layer and through the latter, where the exposure to actinic radiation is carried out in two part-steps, namely in a first part-step over the full area of the polymeric support layer and in a second part-step through an imaging element, which has part-areas which are transparent and part-areas which are opaque to the actinic radiation, where the imaging element is located between the polymeric support layer and a radiation source for actinic radiation and where the duration of the exposure to actinic radiation for the first part-step is sufficient in order to crosslink with polymerisation at least 80% of the photopolymer layer and where the duration of the exposure to actinic radiation for the second part-step is sufficient in order to crosslink with polymerisation the remaining at most 20% of the upper photopolymer layer in the areas where the imaging element is transparent to actinic radiation, in each case based on the layer thickness of the photopolymer layer, viewed from the side of the polymeric support layer.

2. Process according to Claim 1, **characterised in that** the flexographic printing plate additionally has an adhesion-promoting layer between the polymeric support layer and the relief layer and/or a separating layer between the relief layer and the protective layer.

3. Process according to Claim 1 or 2, **characterised in that** the part-areas of the imaging element that are transparent to actinic radiation have a halftone at their outer edges.

4. Process according to one or more of Claims 1 to 3, **characterised in that** the duration of the exposure to actinic radiation for the first part-step is shorter than the duration of the exposure to actinic radiation for the second part-step.

5. Process according to one or more of Claims 1 to 4, where the first part-step is carried out in a time frame of 100 to 200 seconds and the second part-step in a time frame of 120 to 300 seconds, in each case at the same wavelength.

6. Process according to one or more of Claims 1 to 5, **characterised in that**, when the second part-step for exposure to actinic radiation is complete, the protective layer and optionally the separating layer are removed from the relief layer and the uncrosslinked portions of the photopolymer are subsequently removed from the relief layer, forming a structure in the relief layer.

7. Process according to one or more of Claims 1 to 6, **characterised in that** the polymerisation of the photopolymer in the relief layer is completed and the structure obtained in the relief layer is solidified by post-exposure to actinic radiation over the full area from the side of the relief layer.

8. Process according to one or more of Claims 1 to 7, **characterised in that** a structure comprising raised uninterrupted image elements and/or line elements having a width of at least 0.5 mm and comprising intermediate elements lying below the height of the image and line elements, which have a depth of at most 50 µm in relation to the surface of the image and line elements, is obtained in the relief layer.

9. Process according to Claim 8, **characterised in that** image elements and/or line elements are obtained which have a planar surface and side flanks, where the transition from the planar surface to the side flank has the shape of an arc and the length of the arc is selected from the range of the length of an arc formed over a midpoint angle in the range from 10° to 90°, where the circle radius is between 0.1 and 50 µm.

10. Process according to Claim 8, **characterised in that** image elements and/or line elements are obtained which have a cross section which corresponds to the shape of a circle segment, where the segment height corresponds to a maximum of 50 µm and the radius of the respective circle is in the range from 100 to 2000 µm.

11. Flexographic printing plate having a relief layer which has on its surface a structure comprising raised uninterrupted image elements and/or line elements having a width of at least 0.5 mm, and comprising intermediate elements lying below the height of the image and line elements, where the depth of the intermediate elements is at most 50 µm in relation to the surface of the image and area elements, obtainable by a process according to one or more of Claims 1 to 10.

12. Use of a flexographic printing plate according to Claim 11 as embossing tool for an unsolidified binder-containing coating on a substrate or for the transfer of printing ink in a flexographic printing process.

13. Use according to Claim 12, **characterised in that** the binder-containing coating additionally contains flake-form effect pigments.

## Revendications

1. Procédé pour la production d'une structure dans une couche en relief d'une plaque d'impression flexographique, dans lequel la plaque d'impression flexographique comporte au moins une couche de support polymérique, une couche en relief et une couche de protection, selon cette séquence, et dans lequel la couche en relief est une couche en photopolymère et la structure dans la couche en relief est produite en exposant la plaque d'impression flexographique à un rayonnement actinique qui provient de façon exclusive du côté de la couche de support polymérique et qui traverse cette dernière, dans lequel l'exposition au rayonnement actinique est mise en oeuvre selon deux étapes partielles, à savoir selon une première étape partielle au-dessus de l'aire complète de la couche de support polymérique et selon une seconde étape partielle au travers d'un élément imageur, lequel comporte des aires partielles qui sont transparentes et des aires partielles qui sont opaques vis-à-vis du rayonnement actinique, dans lequel l'élément imageur est situé entre la couche de support polymérique et une source de rayonnement pour le rayonnement actinique et dans lequel la durée de l'exposition au rayonnement actinique pour la première étape partielle est suffisante afin de réticuler avec polymérisation au moins 80% de la couche de photopolymère et dans lequel la durée de l'exposition au rayonnement actinique pour la seconde étape partielle est suffisante afin de réticuler avec polymérisation les au plus 20 % restants de la couche en photopolymère supérieure dans les aires au niveau desquelles l'élément imageur est transparent vis-à-vis du rayonnement actinique, dans chaque cas sur la base de l'épaisseur de couche de la couche en photopolymère, tel que vu depuis le côté de la couche de support polymérique.

2. Procédé selon la revendication 1, **caractérisé en ce que** la plaque d'impression flexographique comporte de façon additionnelle une couche favorisant l'adhérence entre la couche de support polymérique et la couche en relief et/ou une couche de séparation entre la couche en relief et la couche de protection.

3. Procédé selon la revendication 1 ou 2, **caractérisé en ce que** les aires partielles de l'élément imageur qui sont transparentes vis-à-vis du rayonnement actinique présentent une demi-teinte ou similigravure au niveau de leurs bords externes.

4. Procédé selon une ou plusieurs des revendications 1 à 3, **caractérisé en ce que** la durée de l'exposition au rayonnement actinique pour la première étape partielle est plus courte que la durée de l'exposition au rayonnement actinique pour la seconde étape partielle.

5. Procédé selon une ou plusieurs des revendications 1 à 4, dans lequel la première étape partielle est mise en oeuvre dans une fenêtre temporelle de 100 à 200 secondes et la seconde étape partielle est mise en oeuvre dans une fenêtre temporelle de 120 à 300 secondes, dans chaque cas à la même longueur d'onde.

6. Procédé selon une ou plusieurs des revendications 1 à 5, **caractérisé en ce que**, lorsque la seconde étape partielle pour l'exposition au rayonnement actinique est terminée, la couche de protection et en option, la couche de séparation, sont enlevées de la couche en relief et les parties non réticulées du photopolymère sont ensuite enlevées de la couche en relief, d'où ainsi la formation d'une structure dans la couche en relief.

7. Procédé selon une ou plusieurs des revendications 1 à 6, **caractérisé en ce que** la polymérisation du photopolymère dans la couche en relief est terminée et la structure qui est obtenue dans la couche en relief est solidifiée au moyen d'une post-exposition au rayonnement actinique sur l'aire complète depuis le côté de la couche en relief.

8. Procédé selon une ou plusieurs des revendications 1 à 7, **caractérisé en ce qu'**une structure qui comprend des éléments d'image et/ou des éléments de ligne non interrompus en surélévation qui présentent une largeur d'au moins 0,5 mm et qui comprend des éléments intermédiaires qui sont présents au-dessous de la hauteur des éléments d'image et de ligne, lesquels présentent une profondeur d'au plus 50 µm en relation avec la surface des éléments d'image et de ligne, est obtenue dans la couche en relief.

9. Procédé selon la revendication 8, **caractérisé en ce que** des éléments d'image et/ou des éléments de ligne sont obtenus, lesquels éléments comportent une surface plane et des flancs latéraux, dans lequel la transition depuis la surface plane jusqu'au flan latéral présente la forme d'un arc et la longueur de l'arc est sélectionnée au sein de la plage de la longueur d'un arc qui est formé sur un angle de point médian dans la plage de 10° à 90°, dans lequel le rayon du cercle est entre 0,1 et 50 µm.

10. Procédé selon la revendication 8, **caractérisé en ce que** des éléments d'image et/ou des éléments de ligne sont obtenus, lesquels présentent une section en coupe transversale qui correspond à la forme d'un segment de cercle, dans lequel la hauteur du segment correspond à un maximum de 50 µm et le rayon du cercle respectif s'inscrit dans la plage qui va de 100 à 2000 µm.

11. Plaque d'impression flexographique qui comporte une couche en relief qui comporte, sur sa surface, une structure qui comprend des éléments d'image et/ou des éléments de ligne non interrompus en surélévation qui présentent une largeur d'au moins 0,5 mm, et qui comprend des éléments intermédiaires qui sont présents au-dessous de la hauteur des éléments d'image et de ligne, dans lequel la profondeur des éléments intermédiaires est d'au plus 50 µm en relation avec la surface des éléments d'image et de ligne, pouvant être obtenue au moyen d'un procédé selon une ou plusieurs des revendications 1 à 10.

12. Utilisation d'une plaque d'impression flexographique selon la revendication 11 en tant qu'outil de gaufrage pour un revêtement contenant un liant non solidifié sur un substrat ou pour le transfert d'une encre d'impression lors d'un processus d'impression flexographique.

13. Utilisation selon la revendication 12, **caractérisée en ce que** le revêtement contenant un liant contient de façon additionnelle des pigments d'effet sous la forme de flocons.
